(19) **Europäisches Patentamt / European Patent Office / Office européen des brevets**

(11) **EP 4 682 493 A1**

(12) # EUROPEAN PATENT APPLICATION

(43) Date of publication:
**21.01.2026 Bulletin 2026/04**

(21) Application number: **24196437.8**

(22) Date of filing: **26.08.2024**

(51) International Patent Classification (IPC):
**G01K 7/01** (2006.01)  **G01K 15/00** (2006.01)

(52) Cooperative Patent Classification (CPC):
**G01K 15/005; G01K 7/01**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.07.2024 KR 20240093286**

(71) Applicants:
• **SKAIChips Co., Ltd.**
**Suwon-si, Gyeonggi-do 16571 (KR)**
• **Research & Business Foundation Sungkyunkwan University Gyeonggi-do 16419 (KR)**

(72) Inventors:
• **Lee, Kang Yoon**
**05834 Seoul (KR)**
• **Oh, Ju Won**
**16325 Suwon-si, Gyeonggi-do (KR)**
• **Jung, Yeon Jae**
**06330 Seoul (KR)**
• **Kim, Kwang Soon**
**31457 Asan-si, Chungcheongnam-do (KR)**
• **Kim, Sung Jin**
**16361 Suwon-si, Gyeonggi-do (KR)**
• **Jo, Jong Wan**
**16418 Suwon-si, Gyeonggi-do (KR)**
• **Pu, Young Gun**
**16684 Suwon-si, Gyeonggi-do (KR)**

(74) Representative: **Grünecker Patent- und Rechtsanwälte PartG mbB Leopoldstraße 4 80802 München (DE)**

(54) **HIGH-PRECISION TEMPERATURE MEASUREMENT CIRCUIT CAPABLE OF PERFORMING EASY CALIBRATION**

(57)    Disclosed is sensing calibration technology for permanently recording a calibration value of a measurement value when a temperature measurement circuit is manufactured. An environment emulating calibration circuit element configured to generate a calibration current emulating an environmental temperature is added to the temperature measurement circuit. The environment emulating calibration circuit element operates to change an output current of a temperature sensing circuit by the amount of change according to the environmental temperature according to a set state value input from an external calibration device during factory calibration. During factory calibration, the external calibration device calculates a calibration value from output values measured while changing a set state of the environment emulating calibration circuit element and sets the calibration value in the temperature measurement circuit.

FIG.1

EP 4 682 493 A1

**Description**

CROSS-REFERENCE TO RELATED APPLICATION(S)

This application claims priority from Korean Patent Application No. 10-2024-0093286, filed on June 15, 2024, in the Korean Intellectual Property Office, the disclosure of which is incorporated herein by reference in its entirety.

BACKGROUND OF THE INVENTION

Field of the Invention

Disclosed is technology related to an electronic circuit, particularly a temperature measurement circuit for detecting temperature.

Description of the Related Art

A temperature measurement circuit measures temperature using a circuit element having characteristics that change with temperature. For example, a threshold voltage in a forward current of a bipolar junction transistor (BJT) element is

$VT = kT/q$, where k is the Boltzmann constant and q is the electron charge, and
changes with temperature. Such temperature characteristics of the BJT element may be used to construct a proportional-to-absolute-temperature (PTAT) circuit having output that increases with temperature or a compliment-to-absolute-temperature (CTAT) circuit having output that decreases with temperature.

When such a temperature measurement circuit is constructed, a process of measuring and calibrating an output value at a standard temperature is required. Conventional one-point calibration determines a calibration value from an output value measured at one temperature, so that only an offset is calibrated, and thus accuracy may decrease depending on the temperature. In contrast, known two-point calibration determines a calibration value from output values measured at two temperatures, so that both an offset and a slope may be calibrated, and thus temperature may be accurately measured when compared to the one-point calibration. However, since output needs to be confirmed by creating low-temperature and high-temperature environments for two-point calibration, the cost of creating environments for calibration during mass production increases.

SUMMARY OF THE INVENTION

Therefore, the present invention has been made in view of the above problems, and it is an object of the present invention to reduce the cost due to two-point calibration.
It is another object of the present invention to provide a temperature measurement circuit capable of reducing manufacturing cost while having high accuracy.
According to an aspect of the proposed invention, an environment emulating calibration circuit element configured to generate a calibration current emulating an environmental temperature is added to a temperature measurement circuit. The environment emulating calibration circuit element operates to change an output current of a temperature sensing circuit by the amount of change according to the environmental temperature according to a set state value input from an external calibration device during factory calibration. During factory calibration, the external calibration device calculates a calibration value from output values measured while changing a set state of the environment emulating calibration circuit element and sets the calibration value in the temperature measurement circuit.
According to an additional aspect, the temperature measurement circuit digitizes the output of the temperature sensing circuit, adds a set calibration value thereto, and then outputs a resultant value.
According to an additional aspect, in the temperature measurement circuit, a preamplification parameter of an analog-to-digital converter (A/D converter) configured to digitize the output of the temperature sensing circuit may be set to a value calculated using the environment emulating calibration circuit element during factory calibration.

BRIEF DESCRIPTION OF THE DRAWINGS

The above and other objects, features and other advantages of the present invention will be more clearly understood from the following detailed description taken in conjunction with the accompanying drawings, in which:

FIG. 1 is a block diagram illustrating a configuration of a temperature measurement circuit and a factory calibration system for the temperature measurement circuit according to an embodiment;

FIG. 2 illustrates a configuration of an environment emulating calibration circuit element according to an embodiment;

FIG. 3 is a flowchart illustrating a configuration of an embodiment of a method of designing the environment emulating calibration circuit element;

FIG. 4 illustrates an embodiment of a temperature sensing circuit of FIG. 1;

FIG. 5 is a flowchart illustrating a configuration of a method of calibrating the temperature measurement circuit according to an embodiment; and

FIG. 6 is a flowchart illustrating a configuration of a method of calibrating the temperature measurement circuit according to another embodiment.

DETAILED DESCRIPTION OF THE INVENTION

The above-described and additional aspects are embodied through embodiments described with reference to the attached drawings. It is understood that components of each embodiment may be combined in various ways within the embodiment or with components of other embodiments unless there is any other mention or contradiction therebetween. Based on the principle that the inventor may appropriately define the concept of a term to describe the invention in the best way, terms used in this specification and claims should be interpreted as having meanings and concept consistent with the described content or a proposed technical idea. Hereinafter, preferred embodiments of the present invention will be described in detail with reference to the attached drawings.

<Description of device invention>

According to one aspect of the proposed invention, an environment emulating calibration circuit element that generates a calibration current emulating an environmental temperature is added to the temperature measurement circuit. This environment emulating calibration circuit element operates to change an output current of the temperature sensing circuit by the amount of change corresponding to an environmental temperature according to a set state value input from an external calibration device during factory calibration. During factory calibration, the external calibration device calculates a calibration value from measured output values while changing a set state of the environment emulating calibration circuit element, and sets the calibration value in the temperature measurement circuit.

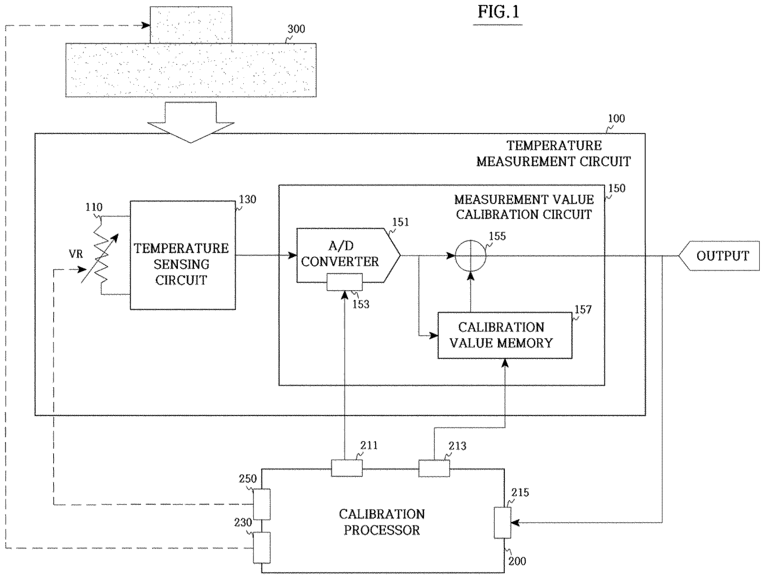

FIG. 1 is a block diagram illustrating a configuration of a temperature measurement circuit and a factory calibration system for the temperature measurement circuit according to an embodiment. As illustrated, the illustrative external calibration device includes a calibration processor 200 and a temperature setter 300. The temperature setter 300 is a device that contacts an upper surface of a semiconductor chip included in a temperature measurement circuit 100 to maintain a temperature thereof at a reference temperature, in this case, at room temperature (23.5°C), and may be configured as a Peltier element, for example. The illustrative calibration processor 200 includes an input port 215 for receiving an output value of the temperature measurement circuit 100, recording ports 211 and 213 for recording the calibration value, a control output port 230 for controlling the temperature setter 300 for measurement, and a setting control port 250 for controlling internal setting of the temperature measurement circuit 100, which is a target of calibration according to the proposed invention.

According to an aspect, the temperature measurement circuit 100, which is a target of calibration, includes a temperature sensing circuit 130, an environment emulating calibration circuit element 110, and a measurement value calibration circuit 150. The temperature measurement circuit 100 according to the proposed embodiment may be used as a temperature sensor by itself, or may be included as a part of a circuit inside another semiconductor device. The temperature sensing circuit 130 is a circuit having characteristics that change with temperature. An electronic device may have characteristics in which specific current characteristics change with temperature since movement of a carrier carrying charge is affected by temperature. For example, in a forward current of a BJT element, a threshold voltage is proportional to temperature according to an equation $VT = kT/q$, where k is the Boltzmann constant and q is the electron charge. There has been a known temperature sensing circuit having output proportional to temperature within an operating range by utilizing this characteristic.

The environment emulating calibration circuit element 110 is connected to the temperature sensing circuit 130 and changes an output current of the temperature sensing circuit 130 according to a set state value input from the external calibration device during factory calibration. In the illustrated embodiment, the environment emulating calibration circuit element 110 is implemented as a variable resistor 110 having a different value according to the set state value input from the external calibration device. According to an additional aspect, the environment emulating calibration circuit element 110 changes an output current to one of two values according to at least two set state values.

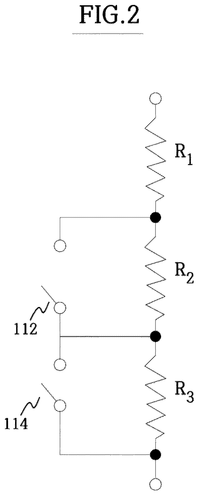

In the illustrated embodiment, the variable resistor 110 included in the environment emulating calibration circuit element 110 may be set to one of three resistance values according to a set state value. FIG. 2 illustrates a configuration of the environment emulating calibration circuit element 110 according to an embodiment. As illustrated, the environment emulating calibration circuit element 110 according to the embodiment includes three resistors R1, R2, and R3 connected in series, and switches 112 and 114 for connecting and disconnecting the resistors R2 and R3. The switches 112 and 114 may be configured as, for example, FET elements.

When all the switches 112 and 114 are turned on, the environment emulating calibration circuit element 110 has a resistance value of R1. This resistance value is designed to output a current value, which is obtained when the temperature sensing circuit 130 is exposed to a high temperature, for example, 90°C while the two resistors R1 and R2 are connected, when the temperature sensing circuit 130 is exposed to room temperature, for example, 23.5°C while only the resistor R1 is connected. When the switches 112 and 114 are all turned off, the environment emulating calibration circuit element 110 has a value obtained by summing resistance values of the three resistors R1, R2, and R3. In this instance, a resistance value of added R3 is designed to output a current value, which is obtained when the temperature sensing circuit 130 is exposed to a low temperature, for example, -40°C while the two resistors R1 and R2 are connected, when the temperature sensing circuit 130 is exposed to room temperature, for example, 23.5°C while the three resistors R1, R2, and R3 are connected. When the switch 114 is turned on, the environment emulating calibration circuit element 110 has a resistance value obtained by adding resistance values of R1 and R2. In the illustrated embodiment, the environment emulating calibration circuit element is implemented as a resistive element. However, the proposed invention is not limited thereto and may be implemented as a capacitive element or an inductive element.

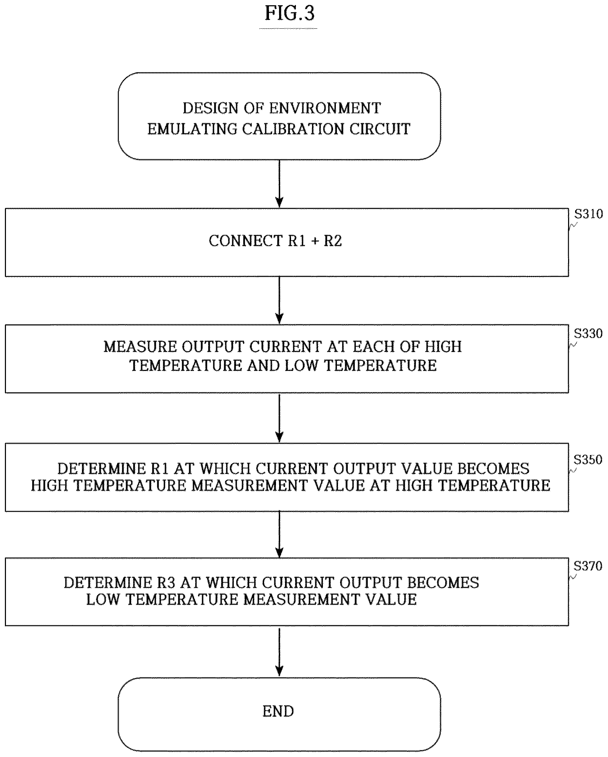

FIG. 3 is a flowchart illustrating a configuration of an embodiment of a method of designing the environment emulating calibration circuit element. First, one resistor corresponding to a constant magnitude, here, R1 + R2 is connected to the temperature sensing circuit (step S310). Even though separate resistance values of R1 and R2 are not determined, a resistance value corresponding to a sum thereof may be appropriately set. Thereafter, an output current is measured at each of a high temperature and a low temperature (step S330). Here, the high temperature is 90°C, and the low temperature is -40°C. In a factory calibration device, the temperature setter 300 may be in contact with the temperature sensing circuit 130, and set a temperature thereof according to a control instruction of the calibration processor.

Thereafter, while the temperature sensing circuit is exposed to room temperature of 23.5°C, a resistance value at which the output current value measured at a high temperature in step S330 is output is determined as a value of R1 (step S350). Thereafter, while the temperature sensing circuit is exposed to room temperature of 23.5°C, a resistance value at which the output current value measured at a low temperature in step S330 is output is determined, and a value of R3 is determined by subtracting R1 + R2 from the resistance value (step S370). These resistance values may be designed by circuit emulation of a design tool without constructing an actual circuit.

The measurement value calibration circuit 150 calibrates and outputs the output of the temperature sensing circuit 130 according to calibration information set from the external calibration device during factory calibration. In general, the output of the temperature sensing circuit deviates from the designed characteristic due to process deviation, and factory calibration is performed for calibration thereof. An error from a designed temperature-current value characteristic is modeled as an offset and a slope in two-point calibration.

In an embodiment illustrated according to an additional aspect, the measurement value calibration circuit 150 includes an A/D converter 151 and an adder 155. The A/D converter 151 converts analog output of the temperature sensing circuit into digital output. The adder 155 adds a set calibration value to the digital output of the A/D converter 151 and outputs a result. In an embodiment, the calibration value may be a constant value unrelated to output of the A/D converter 151. Such a constant may be set in a fuse circuit or an OTP (One Time Programmable) memory. In another embodiment, the calibration value may vary depending on the output value of the A/D converter 151. In this case, a calibration value memory 157 may be provided to store a lookup table. As is known, the lookup table may be configured as a memory that uses an output value of the A/D converter 151 as an address and outputs a calibrated output value stored at the address.

According to an additional aspect, the measurement value calibration circuit 150 may further include a conversion setter 153. The conversion setter 153 sets an offset and a gain value of the A/D converter 151 according to calibration information set from the external calibration device during factory calibration. The A/D converter 151 includes an offset adding circuit and a preamplifier circuit that normalize an input signal according to an input range to sufficiently utilize the resolution. The external calibration device measures an output current of the temperature sensing circuit 130 while changing temperature to measure a range and an offset of an output value in a temperature range specified in the specifications, and sets an offset and a gain value of the A/D converter according to the measured offset and range. However, since the offset and the gain value according to the temperature may be non-linear, the adder 155 may be included to additionally apply a calibration value determined according to the output value.

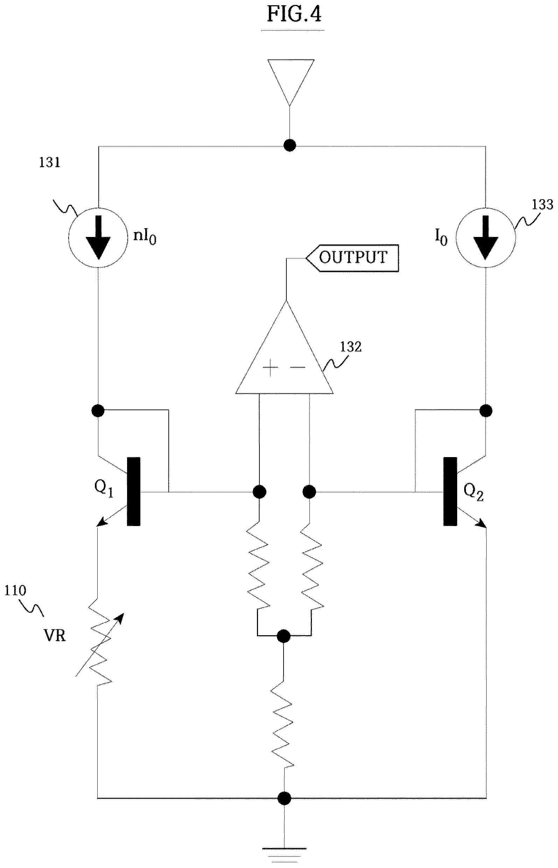

FIG. 4 illustrates an embodiment of the temperature sensing circuit of FIG. 1. The illustrated temperature sensing circuit is simply a typical PTAT circuit to which the environment emulating calibration circuit element 110 is added according to an aspect of the proposed invention. In the illustrated embodiment, the temperature sensing circuit includes a first constant-current circuit 131, a first BJT diode Q1, a second constant-current circuit 133, a second BJT diode Q2, and a comparison circuit 132. An output current $nI0$ of the first constant-current circuit 131 is set to n times an output current $I0$ of the second constant-current circuit 133. Output of the first constant-current circuit 131 is supplied to a collector of the first BJT diode Q1. Output of the second constant-current circuit 133 is supplied to a collector of the second BJT diode Q2. The comparison circuit 132 outputs a differential voltage between an input terminal voltage of the first BJT diode Q1 and an input terminal voltage of the second BJT diode Q2.

In this typical PTAT circuit, a voltage difference between base terminals of the two BJT diodes Q1 and Q2 may be expressed as follows.

$$\Delta V_{BE} = V_{BE1} - V_{BE2}$$
$$= V_T \ln \frac{nI_0}{I_{S1}} - V_T \ln \frac{I_0}{I_{S2}}$$
$$= V_T \ln n$$

Here,

$$\frac{\partial \Delta V_{BE}}{\partial T} = \frac{k}{q} \ln n$$

is satisfied, and thus it can be seen that the voltage difference between the base terminals of the two BJT diodes Q1 and Q2 is proportional to temperature.

According to an aspect of the proposed invention, the temperature sensing circuit further includes the environment emulating calibration circuit element. In the illustrated embodiment, the environment emulating calibration circuit element includes the variable resistor 110. According to an aspect, the variable resistor 110 changes an output current to one of two values according to at least two set state values. The circuit illustrated in FIG. 2 may be one possible embodiment of the variable resistor 110 of FIG. 4. By adjusting the variable resistance, it is possible to check voltages output at high and low temperature environments in a room temperature environment. When the variable resistor 110 is greatly changed, a base voltage of Q1 increases, a collector voltage decreases, and output of the comparison circuit 132 decreases accordingly. The illustrated temperature sensing circuit uses output of a comparator as output of the circuit. However, a CMOS amplifier circuit having a base connected to the constant-current circuits 131 and 133 may be added to an output terminal.

The proposed invention has been described using the PTAT circuit as an example. However, the same principle may be applied to a CTAT circuit.

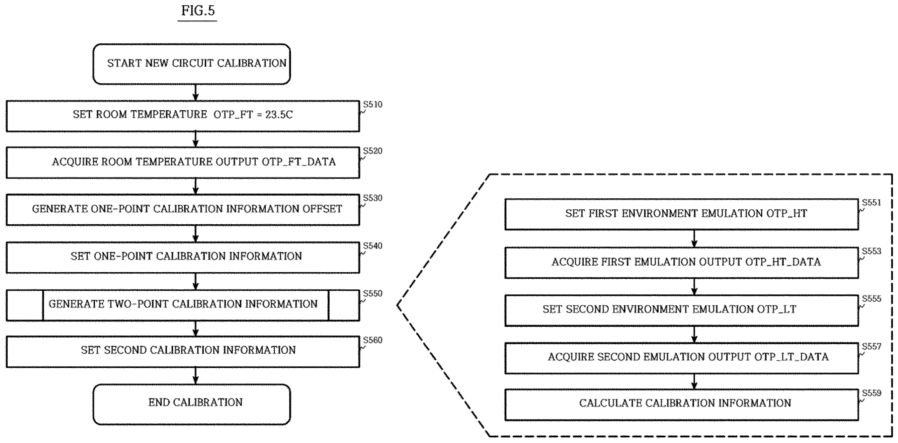

<Description of method invention - embodiment of FIG. 5>

Hereinafter, an invention related to a method of calibrating the temperature measurement circuit will be described. According to an aspect, the temperature measurement circuit to which the presented calibration method is applied may include the temperature sensing circuit, the environment emulating calibration circuit element connected to the temperature sensing circuit to change an output current of the temperature sensing circuit according to an input set state value, and a measurement value calibration circuit that calibrates and outputs the output of the temperature sensing circuit according to set calibration information. For example, the presented calibration method may be implemented using program instructions executed in the calibration device connected to the above-described temperature measurement circuit to calibrate the circuit. The calibration device may include a computing element, such as a microprocessor, and a memory element that stores programs and data. According to an aspect, the temperature measurement circuit, which is a target of calibration, is maintained at a constant temperature, for example room temperature, during a calibration operation.

FIG. 5 is a flowchart illustrating a configuration of a method of calibrating the temperature measurement circuit according to an embodiment. As illustrated, the method of calibrating the temperature measurement circuit according to the embodiment includes a first environment emulation setting step (S551), a first emulation output acquisition step (S553), a calibration information calculation step (S559), and a second calibration information setting step (S560). In the first environment emulation setting step (S551), the calibration device outputs a first set state value corresponding to a first temperature to the environment emulating calibration circuit element. Thereafter, in the first emulation output acquisition step (step S553), the calibration device acquires a first output value of the temperature measurement circuit set to the first set state. The output value of the temperature measurement circuit is an output value passing through the A/D converter 151 in the embodiment illustrated in FIG. 1, and thus is a digital code value. Thereafter, in the calibration information calculation step (S559), the calibration device generates second calibration information from the first output value.

According to an additional aspect, the method of calibrating the temperature measurement circuit according to an embodiment may further include a second environment emulation setting step (S555) and a second emulation output acquisition step (S557). In the second environment emulation setting step (S555), the calibration device outputs a second set state value corresponding to a second temperature to the environment emulating calibration circuit element. Thereafter, in the second emulation output acquisition step (S557), the calibration device acquires a second output value of the temperature measurement circuit set to the second set state. Similar to the first output value, the second output value is a digital code value. Thereafter, in the calibration information calculation step (S559), the calibration device generates second calibration information from the second output value in addition to the first output value.

In an embodiment, the first temperature may be a high temperature, for example, 90°C, and the calibration device outputs the first set state value for setting the environment emulating calibration circuit element so that a current value output when the temperature measurement circuit, which is a calibration target, is exposed to the high temperature is output at room temperature corresponding to a current test environment, for example, 23.5°C. In an embodiment, the second temperature may be a low temperature, for example, - 40°C, and the calibration device outputs the second set state value for setting the environment emulating calibration circuit element so that a current value output when the temperature measurement circuit, which is a calibration target, is exposed to the low temperature is output at room temperature corresponding to the current test environment.

According to an additional aspect, the method of calibrating the temperature measurement circuit may further include one-point calibration to calibrate an offset before two-point calibration. According to this aspect, the temperature measurement circuit to be calibrated is set to room temperature, in this embodiment, 23.5°C (step S510). Setting of room temperature may be achieved by configuring a test chamber as a constant temperature chamber and maintaining a temperature of the entire chamber constant. Alternatively, as illustrated in FIG. 1, setting of room temperature may be achieved using a device in contact with an upper surface of the temperature measurement circuit through the temperature setter 300. According to an aspect, while the calibration method according to the proposed invention is in progress, an environment of the temperature measurement circuit, which is a calibration target, is controlled so that a set constant temperature is maintained.

Thereafter, the calibration device acquires an output value of the temperature measurement circuit at the set room temperature (step S520). Similar to the first output value and the second output value, the output value at this time is a digital code value. The calibration device generates one-point calibration information from the acquired room temperature output value (step S530). One-point calibration information may be an offset value of the temperature measurement circuit. Thereafter, the calibration device outputs the generated one-point calibration information to the measurement value calibration circuit of the temperature measurement circuit and permanently records the one-point calibration information (step S540). For example, this offset may be set by being input as a setting parameter to the conversion setter 153 of the A/D converter 151 in the temperature measurement circuit of FIG. 1. As another example, the one-point calibration information may be reflected by recording overall constant values in the calibration value memory. In this case, the calibration information calculated in step S559 may be recorded by being added to these one-point calibration information values.

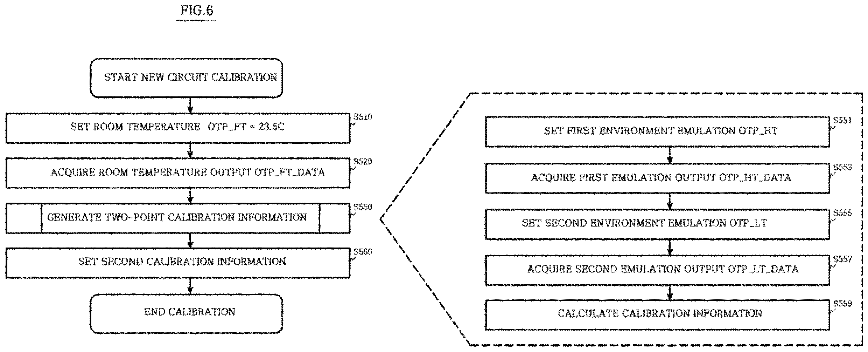

<Description of method invention - embodiment of FIG. 6>

FIG. 6 is a flowchart illustrating a configuration of a method of calibrating the temperature measurement circuit according to another embodiment. Compared to the embodiment of FIG. 5, the embodiment of FIG. 6 does not include step S530 of generating one-point calibration information and step S540 of setting one-point calibration information. That is, in the illustrated embodiment, the calibration information is generated in step S559 from the output value acquired at room temperature in step S520, the first output value acquired in step S553, and the second output value acquired in step S557.

<Description of method invention - generation of calibration information>

Hereinafter, a process of generating the calibration information will be described in detail. The offset value generated in step S530 may be calculated as a difference value between a digital output value at room temperature of an ideally manufactured temperature measurement circuit and a digital output value at room temperature of the temperature measurement circuit, which is a calibration target. When output of the temperature sensing circuit is digitized through an 8-bit A/D converter in a range of -40°C to 87.5°C, output of the A/D converter at room temperature 23.5°C is

$$FT\_TARG = (OTP\_FT + 40)/0.5 = (23.5 + 40)/0.5 = 127.$$

Therefore, when the digital output value at room temperature of the temperature measurement circuit, which is a calibration target, is set to OTP_FT_DATA, an offset value OFFSET may be obtained as

$$\texttt{OFFSET = OTP\_FT\_DATA - FT\_TARG = OTP\_FT\_DATA - 127.}$$

The output of the temperature measurement circuit needs to be output as a temperature value, not as a number in a range of 0 to 255, and thus needs to be output by adding a certain value to the output value of the A/D converter 151 in FIG. 1 by the adder 155. When a value expressing a temperature T in 8 bits in a measurement range of the temperature measurement circuit -40°C to 87.5°C is set to TEMP[7:0][T], a digital temperature output value OFFSET_CAL[T] reflecting an offset in the temperature T may be obtained as follows.

$$\texttt{OFFSET\_CAL[T] = TEMP[7:0][T] - OFFSET}$$

That is, offsets are obtained for all temperature values.

Next, when a digital output value in the case where a high temperature environment of the temperature measurement circuit which is a calibration target obtained in step S553 is set to OTP_HT_DATA, a digital output value in the case where a low temperature environment obtained in step S557 is set to OTP_LT_DATA, a high temperature is set to OTP_HT, and a low temperature is set to OTP_LT, a slope of output of the temperature measurement circuit obtained by two-point calibration may be obtained as follows.

$$slope = \frac{OTP\_HT\_DATA - OTP\_LT\_DATA}{OTP\_HT - OTP\_LT}$$

SLOPE_CAL, a value reflecting this slope in the output value of the A/D converter, that is, a value obtained by applying slope calibration to the output value of the A/D converter undergoing offset calibration, may be obtained as follows.

$$SLOPE\_CAL[T] = (OFFSET\_CAL[T] - FT\_TARG) \times \frac{2}{slope} + FT\_TARG$$

$$= (OFFSET\_CAL[T] - 127) \times \frac{2}{slope} + 127$$

When a code value FT_TARG to be output at room temperature is subtracted from an output value of the A/D converter undergoing offset calibration, a resultant value is multiplied by 2 and then divided by a slope, and then FT_TARG is added thereto, a result value obtained by performing offset and slope calibration on the output of the A/D converter is obtained.

Therefore, a temperature value which is the output of the temperature measurement circuit, that is, a value TEMP obtained by converting the output of the A/D converter into an actual temperature value, may be obtained as follows.

$$TEMP[T] = \frac{(OFFSET\_CAL[T] - FT\_TARG)}{slope} + OTP\_FT$$

$$= \frac{(TEMP[7:0][T] - OTP\_FT\_DATA}{slope} + OTP\_FT$$

$$= \frac{(TEMP[7:0][T] - OTP\_FT\_DATA}{slope} + 23.5$$

When the value calculated above is stored at an address corresponding to the temperature T in the calibration value memory 157 of the measurement value calibration circuit 150 in FIG. 1, the output of the A/D converter 151 of the temperature sensing circuit 130 may be subjected to two-point calibration and output.

It was statistically confirmed that, as a result of calibrating 9000 temperature sensors in a temperature range of -40°C to 90°C by applying the calibration method according to the proposed invention, it is possible to obtain accuracy of about 2 codes, that is, within about 1°C, based on 8-bit A/D conversion.

According to the proposed invention, a temperature measurement circuit having precision equivalent to two-point calibration is achieved without setting an external temperature. Accordingly, manufacturing costs may be reduced by adding a simple circuit to the temperature measurement circuit. In addition, since calibration is carried out at a constant room temperature, a time required for a calibration operation due to temperature change may be eliminated, thereby shortening a calibration time.

Even though the present invention has been described above with reference to the accompanying drawings, the present invention is not limited thereto, and should be interpreted to encompass various modifications that may be easily derived by those skilled in the art. The claims are intended to cover these modifications.

## Claims

1. A temperature measurement circuit comprising:

   a temperature sensing circuit having a characteristic changing with temperature;
   an environment emulating calibration circuit element connected to the temperature sensing circuit to change an output current of the temperature sensing circuit according to a set state value input from an external calibration device during factory calibration; and
   a measurement value calibration circuit configured to calibrate and output an output of the temperature sensing circuit according to calibration information set from the external calibration device during factory calibration.

2. The temperature measurement circuit according to claim 1, wherein the environment emulating calibration circuit element changes the output current to one of two values depending on at least two set state values.

3. The temperature measurement circuit according to claim 1, wherein the measurement value calibration circuit comprises:

   an analog-to-digital converter (A/D converter) configured to convert analog output of the temperature sensing circuit into digital output; and
   an adder configured to add a set calibration value to the digital output of the A/D converter and output a resultant value.

4. The temperature measurement circuit according to claim 3, wherein the measurement value calibration circuit further comprises a conversion setter configured to set an offset and gain of the A/D converter according to calibration information set from the external calibration device during factory calibration.

5. The temperature measurement circuit according to claim 1, wherein the temperature sensing circuit comprises a bipolar junction transistor (BJT) diode to which a constant current is supplied at an input terminal thereof.

6. The temperature measurement circuit according to claim 5, wherein the environment emulating calibration circuit element comprises a variable resistor having one end connected to an output terminal of the BJT diode and having a different resistance value depending on at least two set state values input from an external controller during factory calibration.

7. The temperature measurement circuit according to claim 5, wherein the temperature sensing circuit comprises:

   a first constant-current circuit;
   a first BJT diode having a collector to which output of the first constant-current circuit is supplied;
   a second constant-current circuit;
   a second BJT diode having a collector to which output of the second constant-current circuit is supplied; and
   a comparison circuit configured to output a difference voltage between an input terminal voltage of the first BJT diode and an input terminal voltage of the second BJT diode.

8. The temperature measurement circuit according to claim 6, wherein the environment emulating calibration circuit element comprises a variable resistor having one end connected to an output terminal of the first BJT diode and having a different resistance value depending on at least two set state values input from an external controller during factory calibration.

9. A method of calibrating a temperature measurement circuit, the method executed by a calibration device configured to calibrate the temperature measurement circuit comprising a temperature sensing circuit, an environment emulating calibration circuit element connected to the temperature sensing circuit to change an output current of the temperature sensing circuit according to a set state value, and a measurement value calibration circuit configured to calibrate and output an output of the temperature sensing circuit according to set calibration information, the method comprising;

a first environment emulation setting step of outputting a first set state value corresponding to a first temperature to the environment emulating calibration circuit element;
a first emulation output acquisition step of acquiring a first output value of the temperature measurement circuit;
a second calibration information generation step of generating second calibration information from the first output value; and
a second calibration information setting step of outputting the second calibration information to the measurement value calibration circuit of the temperature measurement circuit and permanently recording the second calibration information.

10. The method according to claim 9, wherein:
between the first emulation output acquisition step and the second calibration information generation step, the method further comprises:

a second environment emulation setting step of outputting a second set state value corresponding to a second temperature to the environment emulating calibration circuit element; and
a second emulation output acquisition step of acquiring a second output value of the temperature measurement circuit, and
the second calibration information generation step comprises generating second calibration information from a second output value in addition to the first output value.

11. The method according to claim 10, wherein:
before the first environment emulation setting step, the method further comprises:

a room temperature setting step of setting the temperature measurement circuit to be calibrated to room temperature; and
a room temperature output acquisition step of acquiring a room temperature output value of the temperature measurement circuit at room temperature, and
the second calibration information generation step comprises generating second calibration information from the room temperature output value, the first output value, and the second output value.

12. The method according to claim 9, wherein:
before the first environment emulation setting step, the method further comprises:

a room temperature setting step of setting the temperature measurement circuit to be calibrated to room temperature;
a room temperature output acquisition step of acquiring a room temperature output value of the temperature measurement circuit at room temperature;
a one-point calibration information generation step of generating one-point calibration information from the acquired room temperature output value; and
a one-point calibration information setting step of outputting the one-point calibration information to the measurement value calibration circuit of the temperature measurement circuit and permanently recording the one-point calibration information.

13. The method according to claim 9, wherein an environment is controlled so that the temperature measurement circuit, which is a calibration target, is maintained at a constant temperature while the method is in progress.

## FIG.1

# FIG.2

## FIG.3

```
┌─────────────────────────────────────┐
│      DESIGN OF ENVIRONMENT           │
│  EMULATING CALIBRATION CIRCUIT       │
└─────────────────────────────────────┘
                  │
                  ▼
┌─────────────────────────────────────────────────────────┐  S310
│                 CONNECT R1 + R2                          │
└─────────────────────────────────────────────────────────┘
                  │
                  ▼
┌─────────────────────────────────────────────────────────┐  S330
│     MEASURE OUTPUT CURRENT AT EACH OF HIGH               │
│       TEMPERATURE AND LOW TEMPERATURE                    │
└─────────────────────────────────────────────────────────┘
                  │
                  ▼
┌─────────────────────────────────────────────────────────┐  S350
│  DETERMINE R1 AT WHICH CURRENT OUTPUT VALUE BECOMES      │
│  HIGH TEMPERATURE MEASUREMENT VALUE AT HIGH TEMPERATURE  │
└─────────────────────────────────────────────────────────┘
                  │
                  ▼
┌─────────────────────────────────────────────────────────┐  S370
│   DETERMINE R3 AT WHICH CURRENT OUTPUT BECOMES           │
│      LOW TEMPERATURE MEASUREMENT VALUE                   │
└─────────────────────────────────────────────────────────┘
                  │
                  ▼
┌─────────────────────────────────────┐
│                END                  │
└─────────────────────────────────────┘
```

# FIG.4

FIG.5

START NEW CIRCUIT CALIBRATION

SET ROOM TEMPERATURE OTP_FT = 23.5C — S510

ACQUIRE ROOM TEMPERATURE OUTPUT OTP_FT_DATA — S520

GENERATE ONE-POINT CALIBRATION INFORMATION OFFSET — S530

SET ONE-POINT CALIBRATION INFORMATION — S540

GENERATE TWO-POINT CALIBRATION INFORMATION — S550

SET SECOND CALIBRATION INFORMATION — S560

END CALIBRATION

SET FIRST ENVIRONMENT EMULATION OTP_HT — S551

ACQUIRE FIRST EMULATION OUTPUT OTP_HT_DATA — S553

SET SECOND ENVIRONMENT EMULATION OTP_LT — S555

ACQUIRE SECOND EMULATION OUTPUT OTP_LT_DATA — S557

CALCULATE CALIBRATION INFORMATION — S559

14

FIG.6

START NEW CIRCUIT CALIBRATION

S510 — SET ROOM TEMPERATURE  OTP_FT = 23.5C

S520 — ACQUIRE ROOM TEMPERATURE OUTPUT OTP_FT_DATA

S550 — GENERATE TWO-POINT CALIBRATION INFORMATION

    S551 — SET FIRST ENVIRONMENT EMULATION OTP_HT

    S553 — ACQUIRE FIRST EMULATION OUTPUT OTP_HT_DATA

    S555 — SET SECOND ENVIRONMENT EMULATION OTP_LT

    S557 — ACQUIRE SECOND EMULATION OUTPUT OTP_LT_DATA

    S559 — CALCULATE CALIBRATION INFORMATION

S560 — SET SECOND CALIBRATION INFORMATION

END CALIBRATION

Europäisches
Patentamt
European
Patent Office
Office européen
des brevets

# EUROPEAN SEARCH REPORT

**Application Number**

EP 24 19 6437

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 648 870 B2 (NXP USA INC [US]) 12 May 2020 (2020-05-12) * abstract * * column 1, lines 8-14,20-31 * * column 1, line 65 - column 2, line 7 * * column 2, lines 26-34,50-53 * * figure 1 * ----- | 1-13 | INV. G01K7/01 G01K15/00 |
| X | US 2014/161149 A1 (SUSAK DAVID MICHAEL [US] ET AL) 12 June 2014 (2014-06-12) * abstract * * paragraphs [0002], [0005] - [0007] * ----- | 1,9 | |

**TECHNICAL FIELDS SEARCHED (IPC)**

G01K

The present search report has been drawn up for all claims

| Place of search | Date of completion of the search | Examiner |
|---|---|---|
| The Hague | 22 January 2025 | Bagnera, Carlo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 6437

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2025

| Patent document cited in search report | | Publication date | Patent family member(s) | | Publication date |
|---|---|---|---|---|---|
| US 10648870 | B2 | 12-05-2020 | CN | 107305147 A | 31-10-2017 |
| | | | EP | 3236224 A1 | 25-10-2017 |
| | | | US | 2017307451 A1 | 26-10-2017 |
| US 2014161149 | A1 | 12-06-2014 | CN | 104903689 A | 09-09-2015 |
| | | | EP | 2929312 A2 | 14-10-2015 |
| | | | US | 2014161149 A1 | 12-06-2014 |
| | | | US | 2017350770 A1 | 07-12-2017 |
| | | | WO | 2014093283 A2 | 19-06-2014 |

EPO FORM P0459

For more details about this annex : see Official Journal of the European Patent Office, No. 12/82

**EP 4 682 493 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240093286